Europäisches Patentamt

European Patent Office

Office européen des brevets

(19)

(11) EP 0 507 728 B1

(12) EUROPÄISCHE PATENTSCHRIFT

(45) Veröffentlichungstag und Bekanntmachung des Hinweises auf die Patenterteilung:
09.10.1996 Patentblatt 1996/41

(51) Int Cl.$^6$: H03F 3/70, G06G 7/186

(21) Anmeldenummer: 92810158.3

(22) Anmeldetag: 03.03.1992

(54) **Ladungsverstärkerschaltung**

Charge amplifier circuit

Circuit d'amplificateur de charge

(84) Benannte Vertragsstaaten:
AT DE FR GB

(30) Priorität: 02.04.1991 CH 969/91

(43) Veröffentlichungstag der Anmeldung:
07.10.1992 Patentblatt 1992/41

(73) Patentinhaber: K.K. HOLDING AG
CH-8408 Winterthur (CH)

(72) Erfinder: Mario, Giorgetta
CH-8408 Winterthur (CH)

(56) Entgegenhaltungen:
DE-A- 3 028 450          DE-B- 2 327 142
DE-C- 2 110 677

• NUCLEAR INSTRUMENTS & METHODS IN PHYSICS RESEARCH/SECTION B, Band 29, Nr. 1-2, November 1987, Seiten 91-93, Amsterdam, NL; DE HAAS et al.: "Pulsed Beam Measurement System"
• PATENT ABSTRACTS OF JAPAN Band 4, Nr. 134 (P-28)(616), 19. September 1980; & JP - A - 5585970

**Beschreibung**

Die Erfindung betrifft eine Ladungsverstärkerschaltung mit einem Regelkreis für die Rückstellung, welcher Regelkreis mindestens einen Operationsverstärker, einen Schalter und zwei antiparallel geschaltete, den Schalter vom Ladungsverstärkereingang entkoppelnde Dioden enthält.

Ladungsverstärkerschaltungen, wie sie beispielsweise in Verbindung mit piezoelektrischen Messwertaufnehmern verwendet werden, haben die nachteilige Eigenschaft, dass der Ausgangs-Bezugspunkt beim Ladungsverstärker abwandert. Dieses Abwandern wird zusammenfassend als Drift bezeichnet. Bei quasistatischen Messungen kann die Drift die Messresultate erheblich verfälschen. Eine Hauptursache der Drift sind die Leckströme am Verstärkereingang. Bei Verwendung eines Halbleiterschalters zur Rückstellung des Ladungsverstärkers entstammen die Leckströme grösstenteils dieser Schalteinrichtung. Diese Leckströme sollten derart niedrig sein, dass sie auch für die anspruchsvollsten der in der Praxis vorkommenden quasistatischen Messungen bedeutungslos werden. Es ist daher bekannt, den Schalter durch zwei antiparallel geschaltete Dioden vom Ladungsverstärkereingang zu entkoppeln (DE-C- 21 10 677).

Dabei ist zu fordern, dass diese Dioden möglichst weitgehend untereinander gleich sind, vor allem also nicht nur möglichst niedrige, sondern auch untereinander möglichst gleiche Leck- oder Reststöme haben. Aus einer Anzahl von Einzeldioden zwei möglichst gleiche mit extrem niedrigen Leckströmen auszuwählen, erfordert einen erheblichen Aufwand. Aufgabe der Erfindung ist es daher, diesen Aufwand zu minimalisieren.

Diese Aufgabe wird dadurch gelöst, dass als Entkopplungsdioden des Regelkreises das Eingangsschutzdiodenpaar eines handelsüblichen integrierten Schaltkreises eingesetzt ist.

Wegen ihres gemeinsamen Aufbaus während der Herstellung sind die geforderten gleichen Eigenschaften bei diesen Dioden zumindest sehr weitgehend gegeben.

Im folgenden werden die einzelnen Schritte, welche zu der Erfindung führten, eingehend anhand von Zeichnungen dargestellt und beschrieben.

Fig. 1     zeigt eine klassische Ladungsverstärkerschaltung
Fig. 2     zeigt eine Ladungsverstärkerschaltung mit einem Regelkreis für Rückstellung
Fig. 3     zeigt die Ursache der Eingangsleckströme in einer Ladungsverstärkerschaltung mit Regelkreis analog Fig. 2 mit elektrisch gesteuertem Schalter
Fig. 4     zeigt ein erklärendes Schaltbild für Fig. 3
Fig. 5     zeigt ein Ausgangsspannungs/Zeit-Diagramm der Schaltung von Fig. 4
Fig. 6     zeigt eine Ladungsverstärkerschaltung mit einem Regelkreis für Rückstellung analog Fig. 2, jedoch ergänzt mit Dioden zwischen Schalter und Ladungsverstärkereingang
Fig. 7     zeigt die Strom-Spannungskennlinie der in Fig. 6 dargestellten Diodenschaltung
Fig. 8     zeigt den erfindungsgemässen Diodenteil der Ladungsverstärkerschaltung nach Fig. 6, Eingangsschutzdioden eines integrierten Schaltkreises verwendend.

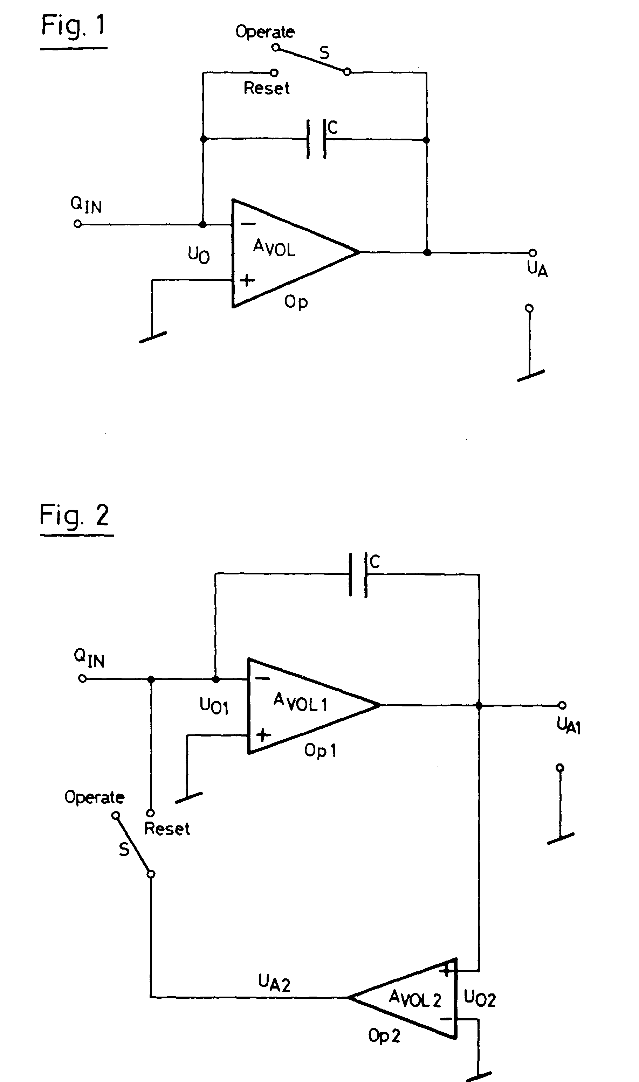

Fig. 1 stellt eine klassische Ladungsverstärkerschaltung dar. Ein piezoelektrischer Kraftaufnehmer beispielsweise gibt bei Belastung eine kraftproportionale elektrische Ladung $Q_{IN}$ an den -Eingang des Operationsverstärks $O_p$ ab, dessen +Eingang geerdet ist und dessen Eingangsoffsetspannung $U_o$ beträgt. Beim idealen Operationsverstärker fliesst kein Strom in den Verstärkereingang und ist die innere Verstärkung $A_{VOL}$ nahezu unendlich, weshalb während des Messvorganges (Schalter S offen, in Operate-Position) die Ladung $Q_{IN}$ auf die Gegenkopplungskapazität C fliesst. Dadurch entsteht am Verstärkerausgang eine Spannung $U_A$ nach der Formel

$$U_A = \frac{-Q_{IN}}{C} + U_o \text{ (Operate)}$$

Die Ausgangsspannung $U_A$ ist somit beim idealen Ladungsverstärker direkt proportional zur vom Aufnehmer abgegebenen Ladung $Q_{IN}$, somit auch proportional zur Messgrösse (z.B. Kraft). Beim Schliessen des Schalters S (Reset-Position) ist die Kapazität $C=\infty$ zu zu setzen. Damit wird

$$U_A = U_o$$

d.h. der Ausgangspunkt für eine neue Messung, durch erneutes Oeffnen des Schalters S, ist wiederum $U_o$.
Beim realen Ladungsverstärker treten Leckströme auf, welche in die Gegenkopplungskapazität C fliessen und dadurch $U_A$ und somit das Messresultat verfälschen. Der Schalter S muss hochisolierend sein und ist im allgemeinen ein recht voluminöses Reed-Relais.

Fig. 2 zeigt eine Ladungsverstärkerschaltung mit einem Regelkreis für Rückstellung. Prinzipiell ist diese Schaltung in der britischen Patentschrift GB 1 330 497 dargelegt und gehört somit seit 1973 zum Stand der Technik. Die folgenden Ausführungsformen lehnen sich alle an die in Fig. 2 dargestellte Ausführungsform an. Bei geöffnetem Schalter S (Operate-Position) arbeitet die Schaltung von Fig. 2 gleich wie jene von Fig. 1, da der Regelkreis für Rückstellung unterbrochen ist, d.h. eine beispielsweise durch eine piezoelektrische Wirkung entstandene Ladung $Q_{IN}$ fliesst auf die Gegenkopplungskapazität C und erzeugt daran eine Spannung $\frac{-Q_{IN}}{C}$. Für die Ausgangsspannung $U_{A1}$ ergibt sich nach dem Oeffnen des Schalters S

$$U_{A1} = + \frac{-Q_{IN}}{C} + U_{o2} \text{ (Operate)}$$

Dies bedeutet, wie bei der Schaltung von Fig. 1, dass die Ausgangsspannung direkt proportional zur vom Aufnehmer abgegebenen Ladung $Q_{IN}$ ist, somit auch proportional zur Messgrösse (Kraft).

Bei Rückstellung (Reset) fliesst die Ladung in der Gegenkopplungskapazität C über den nun geschlossenen Schalter S ab, die Spannung über der Kapazität C wird Null, wodurch

$$U_{A1} = U_{02} \text{ (Reset) wird.}$$

Von diesem Bezugspunkt aus wird eine erneute Messung durch Oeffnen des Schalters S gestartet (Operate-Position). Es ist offensichtlich, dass auch bei dieser Schaltung der Schalter S in geöffnetem Zustand hochisolierend sein muss, damit nicht in der Messphase (Operate, Schalter S offen) Leckströme auf den Ladungseingang $IN_Q$ fliessen und dadurch die Ausgangsspannung $U_{AI}$ und somit das Messresultat verfälschen können. In Fig. 2 bezeichnen weiterhin $U_{o1}$ die Eingangsoffsetspannung des Operationsverstärkers Op1, $U_{A2}$ die Ausgangsspannung des Operationsverstärkers Op2 und $A_{VOL1}$ sowie $A_{VOL2}$ die sehr grossen inneren Verstärkungen der Operationsverstärker Op1 und Op2.

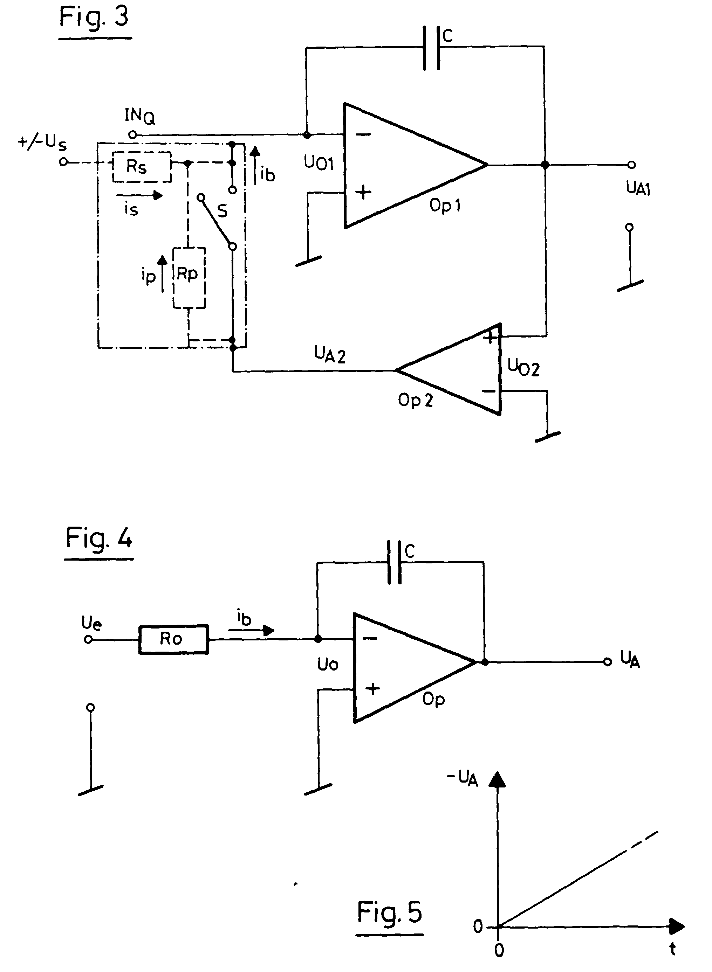

Fig. 3 zeigt eine Ladungsverstärkerschaltung mit elektrisch gesteuerter Schalteinrichtung. Die verwendeten Bezeichnungen haben dieselbe Bedeutung wie in den vorhergehenden Figuren. Der elektrisch gesteuerte Schalter (dargestellt als strichpunktiertes Rechteck) kann beispielsweise ein Halbleiterschalter sein. Die Speisespannung der Schalteinrichtung wird mit $U_s$ bezeichnet. Von der Speisung her gelangt ein Leckstrom $i_s$ über den Isolationswiderstand $R_s$ zum Ladungseingang $IN_Q$ des Ladungsverstärkers. Ein weiterer Leckstrom $i_p$ fliesst über den Isolationswiderstand $R_p$ des offenen Schalters S (im Operate-Zustand). Beide Ströme addieren sich zum Gesamtleckstrom $i_b$. Sie berechnen sich aus den Formeln

$$i_b = i_s + i_p = \frac{U_s - U_{o1}}{R_s} + \frac{U_{A2} - U_{o1}}{R_p} \text{ (Operate)}$$

Der Gesamtleckstrom fliesst während der Messung (Operate-Zustand, Schalter S offen) auf den Ladungseingang $IN_Q$ und verfälscht die Messung, wie bereits dargelegt wurde. Die durch diesen Vorgang verursachte Spannungsänderung von $U_{A1}$ pro Zeiteinheit beträgt

$$\frac{\Delta U_{A1}}{\Delta t} = \frac{-i_b}{C}$$

Beispiel: Bei einer Kapazität C von 100 pF und einem Leckstrom von $10^{-11}$ A (ein praktisch durchaus möglicher Fall), wird gemäss obiger Formel eine Drift von 100 mV/sec erzeugt, was bei einem Vollausschlag des Ausgangssignals $U_A$ von 10V eine Abwanderung von 1% des Vollausschlages pro sec ausmacht. Dieser Wert ist für anspruchsvolle Messungen entschieden zu hoch.

Bei den bisherigen Betrachtungen spielten die durch einen Halbleiterschalter verursachten Leckströme auf den Eingang des Ladungsverstärkers, welche während der Messung Drift verursachen und damit das Messsignal verfälschen, eine dominierende Rolle. Aus diesem Grunde wird in den Figuren 4 und 5 die Folge von Leckströmen in einer Ladungsverstärkerschaltung nochmals schematisch vereinfacht dargestellt.

In Fig. 4 liegt der -Eingang des Operationsverstärkers $O_p$ über einen Widerstand $R_o$ an einer Spannung von $U_o$ gegen Erde, wobei $U_o$ für die anstehenden Betrachtungen praktisch gleich 0 gesetzt werden kann. Auf den -Eingang fliesst demzufolge ein konstanter Strom

$$i_b = \frac{U_e}{R_o} \, ,$$

der über der Gegenkopplungskapazität C und zugleich am Ausgang $U_A$ eine konstante Spannungsänderung gemäss erzeugt.

$$\frac{\Delta U_A}{\Delta t} = \frac{-i_b}{C} \text{ erzeugt.}$$

Der zeitliche Verlauf der Aenderung von $U_A$ ist in Fig. 5 dargestellt. Sie ist zum Zeitpunkt des Einschaltens der Spannungsquelle $U_e$ (t=0 in der Figur) null und verläuft dann linear, wegen der Konstanz des auf die kapazität C fliessenden stromes $i_b$ . Auf diese Weise kommt auch die Drift der Ausgangsspannung $U_A$ in der Schaltung von Fig. 3 zustande.

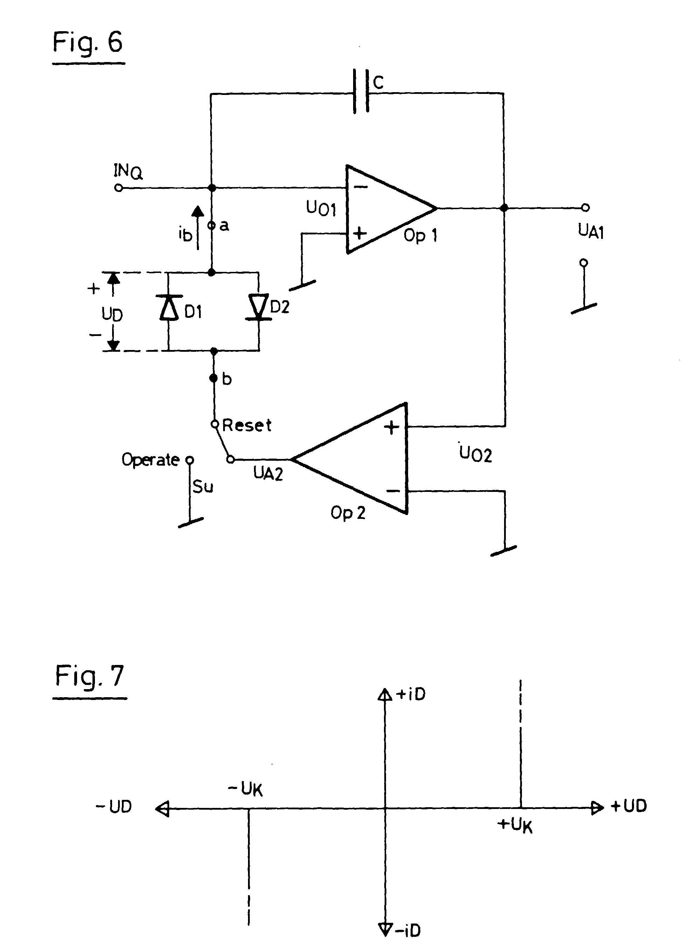

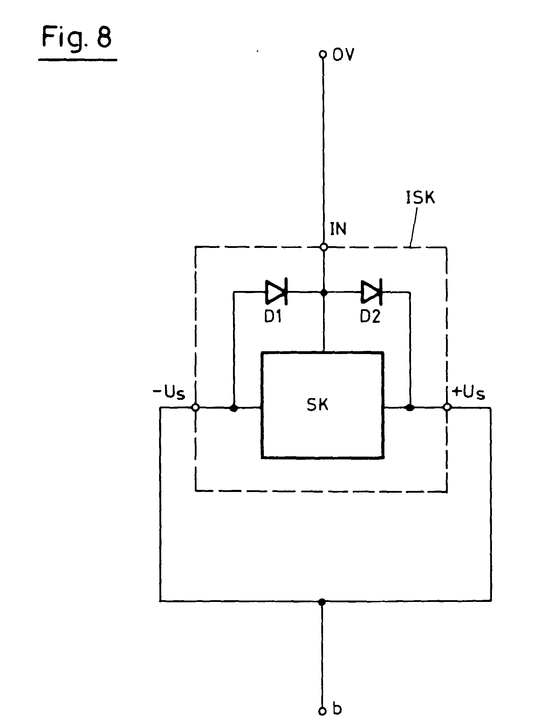

Eine Möglichkeit besagte Drift zu verhindern ist in Fig. 6 dargestellt. Sie zeigt einen Ladungsverstärker mit RückstellRegelkreis, der zwischen Schalter (Halbleiterschalter z.B.) und Eingang $IN_Q$ des Ladungsverstärkers Dioden ent-hält. Die zwei Dioden $D_1$ und $D_2$ sind antiparallel geschaltet. Die Punkte a und b sind Referenzpunkte für die Fig. 8. Die Funktionsweise der genannten Dioden wurde durch die Fig. 7 erklärt. Diese stellt den Strom $i_D$ durch das Diodenpaar als Funktion der Diodenspannung $U_D$ dar. Im Idealfall verläuft die Kennlinie zwischen den beiden Knie spannungen -$U_K$ und +$U_K$ praktisch horizontal, d.h. der Strom $i_D$ durch die Dioden ist sehr gering, deren Widerstand $R_D$ sehr hoch.

$$R_{Do} = \frac{U_D}{i_D} \rightarrow \text{sehr hoch zwischen -}U_K \text{ und +}U_K \text{ (Operate. } R_{Do}= \text{Widerstand während Operate Phase)}$$

$$R_{Dr} = \frac{\Delta U_D}{\Delta i_D} \rightarrow \sim 0 \text{ für } U_D \text{ bei -}U_K \text{ und +}U_K \text{ (Reset. } R_{Dr} = \text{Widerstand während Reset-Phase)}$$

Dies wird ausgenutzt, indem bei Schalterstellung $S_U$ auf Operate Punkt b der Dioden auf gleiches Potential wie der +Eingang des Operationsverstärkers $Op_1$ (hier auf Masse) gelegt wird. Es gilt dann

$$U_D = U_{o1} << |U_K|; R_{Do} \rightarrow \text{sehr hoch}$$

$$i_b = \frac{U_{o1}}{R_{Do}} \rightarrow \text{sehr gering}$$

In der Rückstellphase (Reset, Schalter $S_U$ verbindet Punkt b mit $U_{A2}$ ) liegt die Diodenspannung $|U_D|$ infolge Aussteuerung des Operationsverstärkers Op stets bei $|U_K|$, wodurch deren Widerstand $R_{Dr}$ praktisch null ist.

Dargestellt wurde der Idealfall. In der Praxis verläuft die Diodenkennlinie zwischen den Kniespannungen natürlich nicht genau horizontal, sondern ist leicht geneigt und geht durch den Nullpunkt wie ein ohm'scher Widerstand. Der Widerstand ist also nicht unendlich und ein Leckstrom kann noch auf den Ladungseingang $IN_Q$ gelangen und dadurch das Messresultat verfälschen. Die vorliegenden Ausführungen machen klar, in welcher Richtung Verbesserungen in der vorliegenden Diodenschaltung zu suchen sind, nämlich

$$i_b = \frac{U_{o1}}{R_{Do}} \rightarrow 0, R_{Do} \rightarrow \infty \text{ (Operate)}$$

d.h. es sind Lösungen mit sehr hohem $R_{Do}$ , d.h. mit möglichst horizontaler Kennlinie zwischen den Kniespannungen zu suchen. Eine solche Lösung wurde gefunden. Sie ist in Fig. 8 dargestellt. Fig. 8 zeigt den Diodenteil der in Fig. 7 dargestellten Schaltung mit speziellen Dioden, welche die oben genannten Forderungen erfüllen. Die verwendeten Dioden sind erfindungsgemäss Eingangsschutzdioden eines integrierten Schaltkreises. Solche Dioden dienen zum Schutz der Eingänge heikler Schaltkreise gegen Ueberspannung, wie sie z.B. durch elektrostatische Entladungen entstehen und brauchen die üblichen Anforderungen an allgemeine Dioden nicht zu erfüllen, wie z.B. hohe Sperrspannung oder hohe Strombelastbarkeit.

Dargestellt ist, gestrichelt, der integrierte Schaltkreis ISK, der integriert das Diodenpaar $D_1$ und $D_2$ enthält. Verwendet werden vom integrierten Schaltkreis lediglich die drei Anschlüsse Eingang IN, sowie die Speisungsanschlüsse $-U_s$ und $+U_s$ Der Eingang IN ist über den Punkt a mit dem Ladungsverstärkereingang $IN_Q$ verbunden, die Speisungsanschlüsse $-U_s$ und $+U_s$ werden zusammengeführt und sind über den Punkt b mit dem Schalter $S_U$ verbunden (Fig. 6). Die Analogie mit dem Diodenteil der Schaltung von Fig. 6 ist leicht erkennbar.

Bei Verwendung eines Halbleiterschalters für $S_U$ in Fig. 6 fliessen Leckströme gemäss Fig. 3 in der Operate-Phase nicht mehr auf den Ladungsverstärkereingang $IN_Q$, sondern werden auf Masse abgeleitet.

Die Eingangsschutzdioden können in Sperrichtung elektrisch vorgespannt sein.

Referenzliste

| | |
|---|---|
| S | Schalter (Unterbrecher) |
| $S_U$ | Umschalter |
| Operate | Schalterstellung für Messbetrieb |
| Reset | Schalterstellung für Rückstellung |
| C | Gegenkopplungskapazität |
| Op | Operationsverstärker |
| $Q_{IN}$ | Eingangs ladung |
| $IN_Q$ | Ladungsverstärkereingang |
| $U_o$ | Eingangsoffsetspannung eines Operationsverstärkers |
| $U_A$ | Ausgangsspannung |
| Op1 | Erster Operationsverstärker |
| Op2 | Zweiter Operationsverstärker |
| $U_{o1}$ | Eingangsoffsetspannung des ersten Operationsverstärkers |
| $U_{A1}$ | Ausgangsspannung des ersten Operationsverstärkers |
| $U_{o2}$ | Eingangsoffsetspannung des zweiten Operationsverstärkers |
| $U_{A2}$ | Ausgangsspannung des zweiten Operationsverstärkers |
| $A_{VOL}$ | innere Verstärkung eines Operationsverstärkers |
| $R_s$, $R_p$ | Isolationswiderstände in einem elektrisch gesteuerten Halbleiterschalter |
| $i_s$, $i_p$, $i_b$ | Leckströme |
| $+/-U_s$ | Speisespannung |
| $R_o$ | Eingangswiderstand |
| t | Zeit |
| $U_D$ | Diodenspannung |
| $-U_D$ | Diodenspannung negativ |
| $+U_D$ | Diodenspannung positiv |
| $+i_D$ | Diodenstrom positiv |
| $-i_D$ | Diodenstrom negativ |
| $U_K$ | Diodenschwellspannung oder Kniespannung |
| $R_{Do}$ | Diodenwiderstand bei Operate |
| $R_{Dr}$ | Diodenwiderstand bei Reset |
| a, b | Schaltungsanschlusspunkte |
| IN | Eingangsanschluss |
| $-\lvert U_s \rvert + \lvert U_s \rvert$ | Speisespannungsanschlüsse |
| ISK | Integrierter Schaltkreis mit Eingangsschutzdioden |
| SK | Schaltkreis |

**Patentansprüche**

1.  Ladungsverstärkerschaltung mit einem Regelkreis für die Rückstellung, welcher Regelkreis mindestens einen Operationsverstärker, einen Schalter und zwei antiparallel geschaltete, den Schalter vom Ladungsverstärkereingang entkoppelnde Dioden enthält, dadurch gekennzeichnet, dass als Entkopplungsdioden (D1, D2) des Regelkreises das Eingangsschutz-Diodenpaar eines handelsüblichen integrierten Schaltkreises (ISK) eingesetzt ist.

2.  Ladungsverstärkerschaltung nach Anspruch 1, dadurch gekennzeichnet, dass die Eingangsschutzdioden (D1, D2) in Sperrichtung elektrisch vorgespannt sind.

3. Ladungsverstärkerschaltung nach Anspruch 1 oder 2, dadurch gekennzeichnet, dass der Schalter ($S_u$) ein elektrisch gesteuerter Halbleiterschalter ist.

**Claims**

1. Charge amplifier circuit with a control loop for resetting, this control loop comprising at least one operational amplifier, one switch and two diodes connected antiparallel and decoupling the switch from the charge amplifier input, characterized by the use of the pair of input protection diodes of a commercially available integrated circuit (ISK) as decoupling diodes (D1, D2) of the control loop.

2. Charge amplifier circuit according to Claim 1, characterized by the input protection diodes (D1, D2) being biased electrically in the reverse direction.

3. Charge amplifier circuit according to Claim 1 or 2, characterized by the switch ($S_U$) being an electrically controlled semiconductor switch.

**Revendications**

1. Circuit d'amplificateur de charge avec un circuit de réglage pour la remise à zéro, lequel circuit de réglage comprend au moins un amplificateur opérationnel, un commutateur et deux diodes branchées anti-parallèlement désolidarisant le commutateur de l'entrée de l'amplificateur, caractérisé par le fait que comme diodes de désolidarisation ($D_1$, $D_2$) du circuit réglage on utilise la paire de diodes de protection d'entrée d'un circuit de commutation intégré (ISK) couramment diffusé sur le marché.

2. Circuit d'amplification de charge selon revendication 1 caractérisé par le fait que les diodes de protection d'entrée ($D_1$, $D_2$) sont précontraintes électriquement dans le sens de barrage.

3. Circuit d'amplification de charge selon revendications 1 ou 2 caractérisé par le fait que le commutateur (Su) est un commutateur à semi-conducteur à commande électrique.

## Fig. 1

## Fig. 2

## Fig. 3

## Fig. 4

## Fig. 5

## Fig. 6

## Fig. 7

# Fig. 8